## Europäisches Patentamt

## European Patent Office

## Office européen des brevets

(11) Publication number: **0 089 248**
**B1**

(12) **EUROPEAN PATENT SPECIFICATION**

(45) Date of publication of patent specification: **31.05.89**

(51) Int. Cl.⁴: **H 01 L 23/52, H 01 L 23/48**

(21) Application number: **83301503.5**

(22) Date of filing: **17.03.83**

(54) Dense mounting of semiconductor chip packages.

(30) Priority: **17.03.82 JP 42254/82**

(43) Date of publication of application:
**21.09.83 Bulletin 83/38**

(45) Publication of the grant of the patent:
**31.05.89 Bulletin 89/22**

(84) Designated Contracting States:
**DE FR GB**

(56) References cited:
**WO-A-81/02367**
**FR-A-2 075 958**
**US-A-4 271 426**

**ELECTRONIC DESIGN, vol. 29. no. 12, June
1981, pages 189-194, Waseca, MN, US; E.
HALL: "Packaging struggles to cover the
spread of VLSI with new chip carriers"**
**ELECTRONICS INTERNATIONAL, vol. 55, no. 2,
January 1982, pages 119-123, New York, US; B.
WOODRUFF: "Rectangular chip-carriers double
memory-board density"**

(73) Proprietor: **FUJITSU LIMITED**
**1015, Kamikodanaka Nakahara-ku**
**Kawasaki-shi Kanagawa 211 (JP)**

(72) Inventor: **Akasaki, Hidehiko**
**Miyamachi Koporasu 201, 7-25 Miyamachi**
**Aizuwakamatsu-shi Fukushima 965 (JP)**
Inventor: **Tsujimura, Takehisa**
**Sebun-so 197, Kitamigata Takatsu-ku**
**Kawasaki-shi Kanagawa 213 (JP)**

(74) Representative: **Fane, Christopher Robin King
et al**
**HASELTINE LAKE & CO. Hazlitt House 28
Southampton Buildings Chancery Lane
London, WC2A 1AT (GB)**

(56) References cited:
**WESCON CONFERENCE RECORDS, September
1977, paper no. 15/3, pages 1-7, Norht
Hollywood, US; M.L. BURCH et al.: "Ceramic
chip carrier - the new standard in packaging ?"**

**FUNKSCHAU, vol. 57, no. 20, 1979, pages
1145-1147 Münich, DE; H. SAX: "ICs für
Nf-Leistungsverstärker"**

(56) References cited:
**PATENTS ABSTRACTS OF JAPAN, vol. 6, no.
95 (E-110) 973r, 3rd June 1982; & JP - A - 57
30354 (NIPPON DENKI K.K.) 18-02-1982**

## Description

The present invention relates to dense mounting of semiconductor chip packages.

A module unit of semiconductor devices may be used in order to densely dispose semiconductor devices and in order to obtain a small-sized electronic apparatus. Such a module unit comprises a plurality of semiconductor integrated circuit chips and other electronic parts such as condensers mounted on a ceramic base plate, which base plate includes multilayer printed wiring patterns. The ceramic base plate can be mounted on a printed board so as to provide various electronic circuits.

A leadless package (a leadless chip carrier) has been developed in order to dispose semiconductor packages in a small area. The leadless package has electrode films formed on its surface instead of lead terminals projecting from side surfaces of the package. A plurality of leadless packages are mounted on one main surface of a ceramic base plate, which is mounted on a printed board, so that each leadless package is connected to a circuit pattern formed on the printed board. These leadless packages are used especially when there is a need for dense mounting of semiconductor chip packages. Therefore, the surface of the ceramic base plate should be effectively used for mounting the leadless packages and also the surface of the printed board must be effectively used for mounting the ceramic base plate.

Methods of mounting leadless packages are reviewed in an article by E. Halls in "Electronic Design", vol. 29 (1981) June, No. 12, pages 188—194. For example, on page 190 there is shown a single-in-line package in which eight chips are soldered to a ceramic board with a row of lead pins projecting from one edge of the board. It is also stated that multiple leadless packages have been attached to both sides of ceramic substrates. However, the semiconductor devices of the prior art do not use the full area of the ceramic base plate surface, and the printed board surface, as effectively as is made possible by embodiments of the present invention.

According to an embodiment of the invention, a semiconductor device comprises a plurality of leadless packages, each having a semiconductor chip housed therein and a plurality of electrodes formed on a surface of said leadless package; a base plate having two main surface on which said leadless packages are mounted, said base plate having conductor patterns formed on both of said two main surfaces, said conductor patterns having said electrodes soldered thereto; and a plurality of lead pins which project from only one edge of said base plate in a direction parallel to said two main surfaces. The base plate has a side surface along said one edge, said side surface having pad patterns formed thereon. Each of said lead pins has a connecting portion which is perpendicularly folded, the length of said connecting portion being less than the thickness of said base plate, and a said connecting portion is soldered to each of said pad patterns on said side surface along said only one edge of said base plate. The lead pins are disposed in two rows, the direction of folding of each lead pin in one row being opposite to that in the other row, and the lead pins of the two rows are alternately disposed.

A preferred embodiment of the invention will now be described, by way of example, with reference to the accompanying drawings, in which:

Fig. 1 is an exploded perspective view of a semiconductor device according to the invention, showing how it is assembled;

Fig. 2 is a plan view of part of the device shown in Fig. 1, showing only one row of the lead pins;

Fig. 3 is an end view in the direction of the arrow IV in Fig. 2;

Fig. 4 is an end view, similar to Fig. 3, showing both rows of lead pins in position;

Fig. 5 is a sectional view showing devices such as those shown in Fig. 1 secured to a printed circuit board; and

Fig. 6 is a plan view of the assembly shown in Fig. 5.

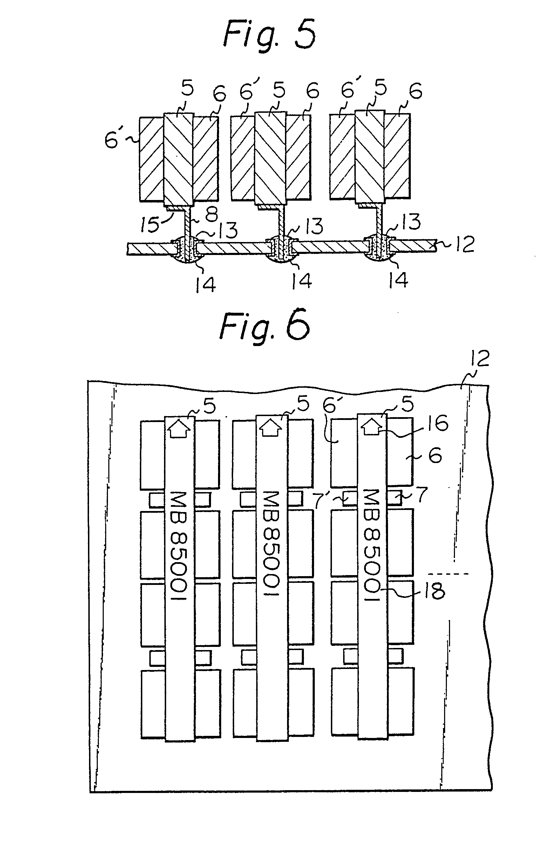

In the embodiment shown, leadless packages 6, 6' and condensers 7, 7' are mounted on both the upper and lower main surfaces of a ceramic base plate 5, and lead pins 8, 8' are attached to the side surface 17 at one edge of the base plate 5 so as to project therefrom parallel to each other and in a direction parallel to the two main surfaces. Each of the lead pins 8, 8' has a connecting portion 15 which is perpendicularly folded and is soldered to a pad pattern (not shown) on the side surface 17. As shown in more detail in Figure 5, the length of the connecting portions 15 is less than the thickness of the base plate.

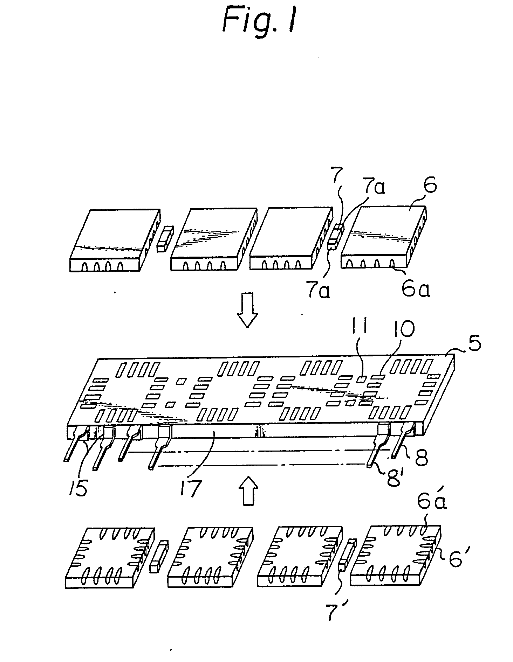

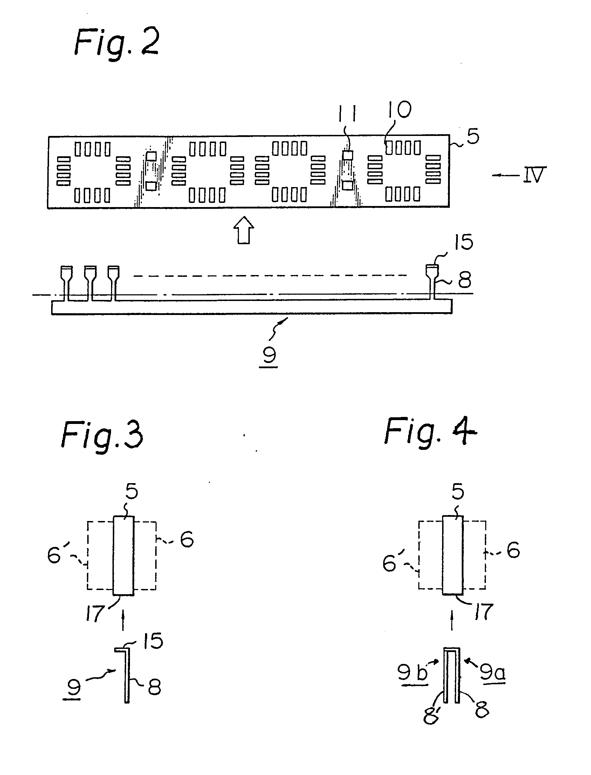

Considering the production of the device in more detail, a plurality of green sheets of alumina, each of which has printed patterns thereon, are laminated and burned so as to constitute a multilayer ceramic base plate 5. As shown in Figure 1, electrode pad patterns 10 and 11 are printed on upper and lower main surfaces of the ceramic base plate 5 where the leadless package 6 and the condenser 7 are to be mounted. Each leadless package 6 comprises a semiconductor chip (not shown) housed therein and a plurality of electrodes 6a formed on the four side surfaces and lower surface thereof. Each electrode pad pattern 10 corresponds to an electrode 6a of the leadless package 6. Also, each electrode pad pattern 11 corresponds to an electrode 7a formed at each end of the condenser 7. Lead pins 8 to be attached to the ceramic base plate 5 are punched from a sheet of metal band so as to constitute a lead frame 9, as shown in Fig. 2. The tip 15 of each lead pin 8 is perpendicularly folded, as is illustrated in Fig. 3. The folded tip 15 is soldered to a pad pattern (not shown) printed on a side surface of the ceramic base plate 5 (the lower side surface in Fig. 3). The melting point of the solder used for securing the lead frame to the ceramic base plate 5 is higher than that of the solder used for securing the leadless packages to the ceramic base plate 5 in a subsequent process. The length of the folded tip 15 is less than the thickness of the ceramic base plate 5. The lead frame 9 is cut along the dash-dot line in Fig. 2, after being soldered to the ceramic base plate 5, so as to form separated lead pins 8. Two such lead frames 9a and 9b, the tip of each being folded in opposite directions, are soldered to the ceramic base plate 5, as is illustrated in Fig. 4. In this arrangement, the lead pins 8, 8' of the lead frames 9a and 9b are alternately disposed. A perspective view of this arrangement is illustrated in Fig. 1. Due to this arrangement, the stability of the ceramic base plate 5 is enhanced when the plate 5 is mounted on the printed board since the lead pins are disposed in two rows. After the lead pins 8 are attached to the ceramic base plate 5, a solder paste is coated on the electrode pad patterns 10 and 11 on the upper and lower main surfaces of the ceramic base plate 5 by means of a printing method. After that, leadless packages 6 and condensers 7 are mounted on the upper main surface of the ceramic base plate 5. The leadless packages 6 and the condensers 7 are adhered to the electrode pad patterns 10 and 11, respectively, with the soldering paste coated thereon. Then the ceramic base plate 5 is turned upside down and placed on an adequate support. Further leadless packages 6' and condensers 7' are mounted on the new upper surface of the ceramic base plate 5. Then the ceramic base plate 5 is heated in a furnace so that the leadless packages 6 and 6' and the condensers 7 and 7' are simultaneously soldered to both of the main surfaces of the ceramic base plate 5.

In order to enhance the adhesiveness of the solder paste before it is heated, another adhesive agent may be coated on a part of the ceramic base plate 5 corresponding to the center portion of each of the parts (the leadless packages and condensers) to be mounted thereon. Thereby, the parts disposed on the upper and lower surface of the ceramic base plate 5 are securely adhered to the ceramic base plate 5 both before and during the heating process for soldering the parts.

In the semiconductor device assembled in the abovementioned manner, the lead pins 8 are secured to the side surface of the caramic base plate 5 instead of being secured to the main surface thereof. Therefore, the entire area of each of the main surfaces of the ceramic base plate 5 is effectively used for mounting the parts, as compared with an arrangement in which the lead pins are soldered to the main surfaces of the base plates. Also, such an arrangement of the lead pins 8 ensures that during the process of printing the solder paste on to the electrode pad patterns 10 and 11, the mask for printing the solder paste closely contacts the ceramic base plate surface so that the printed solder paste precisely corresponds to the mask pattern, with the result that short-circuiting between the adjacent electrode pad patterns can definitely be avoided.

The ceramic base plate 5 having the leadless packages 6 and 6' mounted on both of its main surfaces is mounted on a printed board 12 (Fig. 5) in such a manner that a lead pin 8 is inserted into a through hole 13 of the printed circuit board 12 and is secured thereto with a solder 14.

Fig. 6 is a plan view of the printed circuit board 12 on which semiconductor devices of the present invention are mounted. It is preferable to print an identifying number 18 and an index mark 16 on the upper surface of each base plate 5, so that erroneous mounting of the semiconductor device is avoided and each semiconductor device is easily distinguished.

The distribution or location of the parts mounted on the ceramic base plate 5 is not limited to that illustrated in the drawings. Each of the leadless packages 6, 6' houses, for example, a memory IC chip. The condensers 7, 7' are used as by-pass condensers. If the memory capacity of the memory IC chip is 64 kbit, then a memory module of 64 kwords×8 bit or 512 kwords×1 bit can be constituted in accordance with the illustrated embodiment. Also resistances or other electronic parts may be mounted on the ceramic base.

As was indicated above, the use of semiconductor devices embodying the present invention can enable electronic parts to be mounted with a desirably high packaging density, owing to the more efficient use of the mounting surfaces available.

**Claims**

1. A semiconductor device comprising:
a plurality of leadless packages (6, 6'), each having a semiconductor chip housed therein and a plurality of electrodes formed on a surface of said leadless package;
a base plate (5) having two main surfaces on which said leadless packages (6, 6') are mounted, said base plate having conductor patterns formed on both of said two main surfaces, said conductor patterns having said electrodes soldered thereto; and
a plurality of lead pins (8, 8') which project from only one edge of said base plate in a direction parallel to said two main surfaces, wherein
—said base plate (5) has a side surface (17) along said one edge, said side surface having pad patterns formed thereon,
—each of said lead pins (8, 8') has a connecting portion (15) which is perpendicularly folded, the length of said connecting portion being less than the thickness of said base plate,
—said connecting portion is soldered to each of said pad patterns on said side surface along said only one edge of said base plate,
—said lead pins (8, 8') are disposed in two rows, the direction of folding of each lead pin in one of the rows being opposite to that in the other row, and
—the lead pins of the two rows are alternately disposed.

2. A device as claimed in claim 1 wherein said base plate is a multi-layer ceramic plate.

3. A device as claimed in claim 1 or claim 2, wherein at least one of the semiconductor chips is a semiconductor memory chip.

## Patentansprüche

1. Halbleitervorrichtung mit:
einer Vielzahl von leitungslosen Packungen (6, 6'), die jeweils ein Halbleiterchip, welches darin enthalten ist, und eine Vielzahl von Elektroden haben, die auf der Oberfläche der genannten leitungslosen Packung gebildet sind;
einer Basisplatte (5), die zwei Hauptoberflächen hat, auf welcher die genannten leitungslosen Packungen (6, 6') montiert sind, welche genannte Basis Leitungsmuster hat, die auf beiden genannten Hauptoberflächen gebildet sind, an welchen Leitungsmustern die genannten Elektroden angelötet sind; und
einer Vielzahl von Leitungsstiften (8, 8'), welche von lediglich einem Rand der genannten Basisplatte in eine Richtung parallel zu den genannten beiden Hauptoberflächen vorstehen, bei welcher
—die genannte Basisplatte (5) eine Seitenoberfläche (17) längs dem gennanten eine Rand hat, auf welcher genannten Seitenoberfläche Pad-Muster ausgebildet sind,
—jeder der genannten Leitungsstifte (8, 8') einen Verbindungsabschnitt (15) hat, der senkrecht gefaltet ist, wobei die Länge des genannten Verbindungsabschnittes geringer als die Dicke der genannten Basisplatte ist,
—der genannte Verbindungsabschnitt an jedem der genannten Pad-Muster auf der genannten Seitenoberfläche längs dem genannten lediglich einen Rand der Basisplatte angelötet ist,
—die genannten Leitungsstifte (8, 8') in zwei Reihen angeordnet sind, wobei die Richtung der Faltung von jedem Leitungsstift in einer der Reihen entgegengesetzt zu derjenigen in der anderen Reihe ist, und
—die Leitungsstifte der beiden Reihen alternativ angeordnet sind.

2. Vorrichtung nach Anspruch 1, bei der die genannte Basisplatte eine vielschichtige Keramikplatte ist.

3. Vorrichtung nach Anspruch 1 oder 2, bei der wenigstens eines der genannten Halbleiterchips ein Halbleiterspeicherchip ist.

## Revendications

1. Dispositif à semiconducteurs comprenant:
plusieurs boîtiers sans fil (6, 6') logeant chacun une puce semiconductrice et comportant plusieurs électrodes qui sont formées sur une surface dudit boîtier sans fil;
une plaque de base (55) possédant deux surfaces principales sur lesquelles sont montés lesdits boîtiers sans fil (6, 6'), chaque plaque de base possédant des configurations conductrices formées sur ses deux surfaces principales, lesdites électrodes étant soudées auxdites configurations conductrices; et
plusieurs broches de câblage (8, 8') qui font saillies d'un seul bord de ladite plaque de base suivant une direction parallèle auxdites deux surfaces principales, où:
ladite plaque de base (5) possède une surface latérale (17) suivant ledit bord, des configurations faisant fonction de polts étant formées sur ladite surface latérale,
chacune desdites broches de câblage (8, 8') possède une partie de connexion (15) qui est perpendiculairement repliée, la longueur de ladite partie de connexion étant inférieure à l'épaisseur de ladite plaque de base,
ladite partie de connexion est soudée à chacune desdites configurations faisant fonction de plots situées sur ladite surface latérale suivant ledit bord de ladite plaque de base,
lesdites broches de câblage (8, 8') sont disposées suivant deux rangées, le sens de pliage de chaque broche de câble appartenant à une des rangées étant opposé à celui de l'autre rangée, et
les broches de câbles des deux rangées sont disposées en alternance.

2. Dispositif selon la revendication 1, où ladite plaque de base est une plaque en céramique multicouche.

3. Dispositif selon la revendication 1 ou 2, où au moins une des puces semiconductrices est une puce de mémoire semiconductrice.

# Fig. 1

# Fig. 2

# Fig.3

# Fig. 4

# Fig. 5

# Fig. 6